# EUROPEAN PATENT SPECIFICATION

(11) **EP 1 618 650 B1**
(45) Date of publication and mention of the grant of the patent: **06.09.2006**
(21) Application number: 03727405.7
(22) Date of filing: 30.04.2003
(51) Int. Cl.: H03F 1/32, H03G 3/30, H03G 3/20

(54) **METHOD AND DEVICE FOR POWER AMPLIFIER WITH HIGH ACCURACY OF AN OUTPUT SIGNAL**
VERFAHREN UND VORRICHTUNG FÜR EINEN LEISTUNGSVERSTÄRKER MIT HOHER GENAUIGKEIT EINES AUSGANGSSIGNALS
PROCEDE ET DISPOSITIF DESTINES A UN AMPLIFICATEUR DE PUISSANCE DE SIGNAL DE SORTIE HAUTE PRECISION

(43) Date of publication of application: 25.01.2006
(73) Proprietor: TELEFONAKTIEBOLAGET LM ERICSSON (publ), 164 83 Stockholm (SE)
(72) Inventor: KEHLENBACH, Werner, 90491 Nürnberg (DE); LIPKA, Dietmar, 92348 Berg (DE)
(74) Representative: Pfeifer, Torsten
(86) International application number: PCT/EP2003/004526
(87) International publication number: WO 2004/098045

(56) References cited:
- EP-A- 0 598 585
- WO-A-03/019773
- GB-A- 2 348 062
- US-A1- 2001 022 532
- US-A1- 2002 158 622
- US-A1- 2002 193 086

## Description

### FIELD OF INVENTION

The present invention relates to a method and a device for improving the output signal accuracy of a power amplifier in a transmitter. More specifically, the invention relates to a method and a device for improving the output signal accuracy of power amplifiers in conjunction with digital predistortion.

### BACKGROUND OF THE INVENTION

Efficient multiple access techniques are an important prerequisite to guarantee the high traffic handling capacities of modern telecommunication systems. Multiple access techniques permit a plurality of users to simultaneously access a specific resource by dividing a common communications medium into individual channels.

There are three basic types of multiple access techniques, namely frequency division multiple access (FDMA), time division multiple access (TDMA) and code division multiple access (CDMA). Unlike FDMA and TDMA, CDMA allows a plurality of different traffic channel signals to be simultaneously transmitted in such a way that they overlap in both the time and the frequency domain. In order to distinguish each traffic channel signal from the other traffic channel signal, each traffic channel signal is encoded with one or more unique spreading codes, as is well-known in the art. The individual traffic channel signals are eventually combined into a single, multicode CDMA signal, which is upconverted and amplified prior to transmission.

Combining multiple traffic channel signals into a single CDMA signal or independent CDMA signals into a combined CDMA signal is advantageous in that only a single power amplifier is required rather than a separate power amplifier for each traffic channel signal or each independent CDMA signal. However, the combination of individual traffic channel signals or independent CDMA signals leads to a significantly increased peak-to-average power ratio associated with the resulting power amplifier input signal. The drawback associated with a large peak-to-average power ratio is that it limits the power amplifier efficiency.

However, power amplifiers need to be frequency efficient. That means that power emissions of the power amplifiers into adjacent channels have to be kept below certain limits and that power amplifiers need to provide a high degree of linearity. If power amplifiers are run close to saturation high peak values lead to significant intermodulation distortion, such that adjacent channels experience significant interference. So far one solution has been to run amplifiers with substantial back-off to prevent signal peaks from causing high non-linear distortion and out-of-band emissions. This approach, however, has the disadvantage that power amplifiers are an expensive part of a communication system. Power amplifiers with high back-off result in significant extra cost for the system. In addition power amplifiers with high back-off cause size as well as heat dissipation problems. Therefore, one aims at employing power amplifiers with a minimum back-off and, at the same time, at avoiding non-linear distortions in the amplified signal for transmission.

One option to achieve this aim has been to apply various linearization techniques allowing amplifiers to run closer to their saturation point without exceeding given power emission limits in adjacent channels. One of these techniques with promising perspectives is digital predistortion. A possible implementation of digital predistortion uses a comparison of the original baseband input signal with the signal for transmission at the output of the power amplifier, i.e. at the antenna reference point. For this purpose, the output signal is fed back into a digital predistortion unit via a feedback branch comprising down-conversion of the signal from the radio frequency (RF) for transmission, e.g. into baseband, and analog-to-digital conversion of the signal. The difference between the input signal and the downconverted feedback signal from the power amplifier is used to intentionally distort the baseband signal prior to analog amplification such that non-linearities are significantly reduced in the output signal of the power amplifier.

The major drawback of this solution results from the fact that predistortion is performed according to the feedback signal, generally in the digital domain. Therefore the signal for transmission at the output of the power amplifier needs to be down-converted to a low intermediate frequency (IF) or even to baseband and is generally also analog-to-digital converted. The downconversion requires one or even several mixing units, analog IF-filters and amplifiers. This analog equipment in communication system components such as radio base stations or mobile terminals is subject to high variations associated with environmental temperature and also aging and power supply variations. These effects lead to a continuously changing analog gain of the RF down-conversion unit. Due to the fact that the digital predistortion unit does not have precise information about the power level at the antenna reference point but relies only on the down-converted signal of the feedback branch coming from the power amplifier output, all gain uncertainties of the down-conversion feedback branch have a direct impact on the quality of the digitally predistorted signal. These gain uncertainties in the down-conversion feeback branch cause output power variations of the same magnitude.

Especially in CDMA systems like for example wideband CDMA, the output power of a radio base station or a mobile terminal has to be controlled accurately in order to avoid unnecessary interferences and therefore not to sacrifice cell and spectrum capacity. The solution so far has been to keep the gain uncertainty of the down-conversion chain in the feedback branch as low as possible. This approach, however, suffers from the disadvantage that the down-conversion components become very expensive, need a relevant amount of space in a hardware implementation and finally result in additional heat dissipation.

Several improvements have been proposed in order to improve the performance of an amplifier in a transmitter with a feedback loop. Application GB 2348062 describes an arrangement for linearizing the output of a transmitter.

Application US2002/193086 shows a transmitter with two parallel feedback branches, which provide feedback in different frequency bands.

Document US2002/158622 discloses a feedback amplifier, in which an additional measurement arrangement is provided to estimate the phase error of the feedback loop. The measuring arrangement estimates the loop-phase error from the output of the amplifier on the basis of a test signal.

European application EP 598585 describes an automatic calibration procedure for an amplifier with signal feedback. The amplifier comprises a feedback branch with signal strength measurement, which is used for the calibration based on test signals.

However, none of the above documents provides a solution for improving the accuracy of the feedback signal in a simple way.

### SUMMARY OF THE INVENTION

It is therefore an object of the present invention to overcome the above-mentioned problems and to provide a method for improving output signal accuracy of power amplifiers in a transmitter.

According to the invention, the method described in claim 1 is performed. Furthermore, the invention is embodied in a computer program product and a transmitter as described in claims 5 and 7, respectively. Advantageous embodiments are described in the further claims.

The proposed method for improving the output signal accuracy concerns a transmitter with a forward branch for converting an input signal into a signal for transmission. The forward branch comprises an adaptation unit for applying a predistortion to the input signal and a power amplifier. The transmitter furthermore has a first feedback branch, the first feedback branch generating a feedback signal from the signal for transmission. The generation of the feedback signal may for example comprise the steps of branching the signal from the antenna reference point, attenuating it or performing further conversion steps as described with respect to preferred embodiments.

The feedback signal is fed back to the adaptation unit and the predistortion applied to the input signal is determined according to the feedback signal. According to the invention the output power of said signal for transmission is measured in a second feedback branch and the predistortion is adjusted according to said measurement of the output power. It should be noted that the adjustment can either be performed on the feedback signal before it is forwarded to the adaptation unit or the adjustment may be performed by the adaptation unit itself. Preferably, however, adjusting according to said measurement is performed on the feedback signal, either within or before the adaptation unit. A major advantage of using a second feedback branch is that the power measurement can be performed without prior processing stages for signal conversion, which significantly improves the measurement precision. It is furthermore possible to correct inaccuracies in the amplification of the first feedback branch allowing for a cheap implementation.

More generally, the concept of the invention is to overcome the gain uncertainties of the processing units in the first feedback branch which have an impact on the digital predistortion quality by measuring the output power of the power amplifier in a second feedback branch and compensating gain variations of said one or more processing units of the first feedback branch.

Due to the fact that the gain variations in the downconverter are rather slow compared to the signal dynamic itself, gain correction data for the digital adaptation unit can be provided rather slowly as well. Therefore, the output power is preferably measured by an integrating method.

Any signal to be transmitted by an antenna will be analog in nature, however predistortion is preferably performed in the digital domain. Preferably, the adaptation unit is therefore a digital adaptation unit. If the output signal of the above mentioned power amplifier is fed back to the digital adaptation unit, the output signal needs to be downconverted to an intermediate frequency or to baseband and needs to be analog-to-digital converted. Therefore, the first feedback branch comprises preferably a downconverter unit and an analog-to-digital-converter.

The output power measurement values may be subject to further processing for calculating gain compensation. Especially, the gain compensation may be calculated by a method which further comprises the steps of comparing the analog-to-digital converted values of the first feedback branch with the analog-to-digital converted output power measurement values of the second feedback branch, deriving a correction factor from said comparison and multiplying said analog-to-digital converted values of the first feedback branch with said correction factor. In this way, a simple compensation of gain variations may be achieved.

In order to provide corrections for gain uncertainties of the first feedback branch to the digital adaptation unit, the RF downconverted signals may be integrated such as the output power measurement signals. If gain correction data shall be calculated after an analog-to-digital conversion it is advantageous to make use of the same time constant for integrating the RF-downconverted signals and for the output power measurement. This allows a frequent comparison of the RF-downconverted signals of the first feedback branch and the power measurements of the second feedback branch and can be easily implemented. Therefore in a preferred embodiment of the method the time constant used for integrating the output power measurement of the second feedback branch and for integrating said analog-to-digital-converted values of the first feedback branch are the same.

The invention can be implemented as a hardware solution or as a computer program product comprising program code portions for performing the steps discussed above when the computer program product is run on a computing device. The computer program product may be stored on a data carrier in fixed association with or removable from the computing device.

A transmitter according to the invention has a forward branch for converting an input signal into a signal for transmission. The forward branch comprises an adaptation unit for applying a predistortion to the input signal and a power amplifier. The transmitter furthermore has a first feedback branch being adapted to generate a feedback signal from the signal for transmission. The first feedback branch is connected to the adaptation unit, either directly or via intermediate units, which may perform a processing of the signal. The adaptation unit is adapted to determine said predistortion according to the feedback signal.
The amplification characteristic of the first feedback branch may be inaccurate and/or varying. Therefore,the transmitter comprises also a second feedback branch with a measurement unit for the output power of said signal for transmission. The second feedback branch is connected to the adaptation unit. The transmitter is adapted to adjust the predistortion according to said measurement of the output power. Again, the connection second feedback branch and adaptation unit may either be a direct connection or an indirect connection, i.e. the output of the second feedback branch may be fed into a further unit, e.g. into the first feedback branch, and the output of the further unit is then provided to the adaptation unit.

Both the transmitter and the computer program product described before may be adapted to any embodiment of the above method.

In a preferred transmitter the first feedback branch contains at least a frequency converter, e.g. an RF-downconverter, and an analog-to-digital-converter. Since the output of the power amplifier is an analog RF-signal, the signal first needs to be downconverted to baseband or at least an intermediate frequency range and then needs to be analog-to-digital converted in order to produce a digital input signal for a digital adaptation unit.

In an advantageous transmitter, the measurement unit is an integrating measurement unit, allowing for a low implementation effort and low costs. Preferably, the measurement unit is working at radio frequency in the analog domain.

The compensation of the gain uncertainties of the first feedback branch may be performed in a compensation unit, which provides the corrected input to the adaptation unit, preferably a digital adaptation unit. In this case, the compensation unit may be part of the first feedback branch and an adaptation unit according to the state of the art may be used. However, gain compensation may as well be performed within the adaptation unit if the adaptation unit is provided with the output signals of the first and the second feedback branch, respectively.

Preferably, the adaptation unit is a predistortion unit. In the state of the art, especially CDMA transmitters often comprise a predistortion unit, which may also be used for performing the predistortion in the method and transmitter according to the invention. In this way, it is possible to implement the invention with a low effort using existing hardware. It is however also feasible that the predistortion according to the invention is limited to a power control.

The foregoing and other objects, features and advantages of the present invention will become more apparent in the following detailed description of preferred embodiments as illustrated in the accompanying drawings.

### BRIEF DESCRIPTION OF THE DRAWINGS

In the following the invention will be described with reference to preferred embodiments illustrated in the figures, in which:
- Fig. 1: shows a digital predistortion transmitter including a feedback branch as it is known in the art.
- Fig. 2: shows a digital predistortion transmitter including a first and second feedback branch, where the output power of the power amplifier is measured in the second feedback branch according to the present invention.
- Fig. 3: shows an embodiment for compensation of the gain variations of the first feedback branch

### DETAILED DESCRIPTION OF PREFERRED EMBODIMENTS

In the following description, for purposes of explanation and not limitation, specific details are set forth, such as particular embodiments, circuits, signal formats etc. in order to provide a thorough understanding of the present invention. It will be apparent to one skilled in the art that the present invention may be practiced in other embodiments that depart from these specific details. In particular, while the different embodiments are described herein below incorporated with a Wideband CDMA transmission device, the present invention is not limited to such an implementation, but for example can be utilized in any transmission device in which a signal adaptation can be performed in the forward branch, e.g. an analog or digital predistortion. Moreover, those skilled in the art will appreciate that the functions explained herein below may be implemented using individual hardware circuitry, using software functioning in conjunction with a programmed microprocessor or general purpose computer, using an application specific integrated circuit (ASIC), and/or using one or more digital signal processors (DSPs).

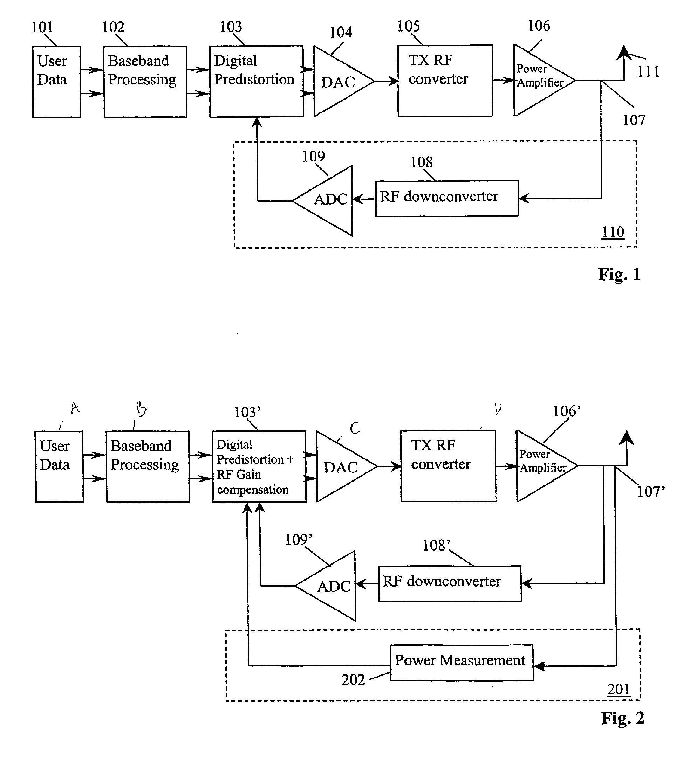

Fig. 1 shows a digital predistortion transmitter as it is known in the art, which forms the basis for explanation purposes of embodiments of the present invention shown in the following figures. The digital predistortion transmitter basically consists of three parts: the source of input data for the digital adaptation unit, which have been processed in the digital domain by units 101 and 102 prior to digital predistortion, a forward branch with several units (104, 105, 106) between the digital adaptation unit 103 and the antenna reference point 107 and a feedback branch 110 with an RF-downconversion unit 108 and an analog-to-digital converter unit 109 between the antenna reference point 107 and the digital adaptation unit 103.
The output of the user data unit 101 is connected to the input of the baseband processing unit 102. In the case of the WCDMA of the present example, user data consist of an inphase component I and a quadrature component Q represented by two connection lines between the units, respectively. Therefore two connection lines are shown between the different processing units in the digital domain, i.e. between the units 101, 102, 103 and 104. As is apparent to one skilled in the art, user data does not need to be QPSK modulated for transmission, but may be represented by other signal types as well, as e.g. BPSK, 8-PSK, QAM signals or signals of other possible modulation schemes. The baseband processing unit 102 is adapted to perform one or more processing steps on the signal from a group comprising encoding, interleaving, baseband modulation, channel spreading using a binary channel code sequence, channel weighting, channel combination, and multiplication with a complex scrambling code.
The output of the baseband processing unit 102 is connected to digital adaptation unit 103. Digital predistortion relies on the comparison between the transmitted signals and original signals. As this comparison is preferably performed in the digital domain, the transmitted signal at the antenna reference point 107 is downconverted to an intermediate frequency range or even into baseband in the RF downconverter unit 108 and is analog-to-digital (ADC) converted in the ADC unit 109, both being part of the feedback branch 110. For the mentioned downconversion one or more analog mixing stages, analog IF filters and amplifiers are required. As is apparent to one skilled in the art, the processing stages in the feedback branch 110 cause gain uncertainties, which have an impact on the digital predistortion result produced by the digital adaptation unit 103.
The output of the digital adaptation unit 103 is connected to the input of the DAC unit 104, where data are digital-to-analog converted. The analog signals output from the DAC unit 104 are then converted to a radio frequency range in the TX RF converter unit 105 and amplified in the power amplifier 106 before being transmitted over the air interface at the antenna 111.

Referring to Fig. 2 a preferred embodiment of the present invention is shown. Components already described with respect to figure 1 perform corresponding functions in figure 2. However, the embodiment departs from figure 1 by the fact that it contains a second feedback branch 201 between the antenna reference point 107' and the digital predistortion and RF gain compensation unit 103'. Within this second feedback branch a measurement of the output power of power amplifier 106' is accomplished by power measurement unit 202. Depending on the embodiment of the power measurement unit 202 the measurement may e.g. be performed in an integrating or a non-integrating manner. An example of an integrating measurement unit is a thermal power detector. The measurement result is then forwarded to digital adaptation unit 103'. In addition to the functions described with respect to figure 1, unit 103' adjusts the feedback signal received from ADC unit 109' according to the measurement result. Accordingly, variations in the gain of the first feedback branch are compensated in a precise, simple and cost-efficient way.

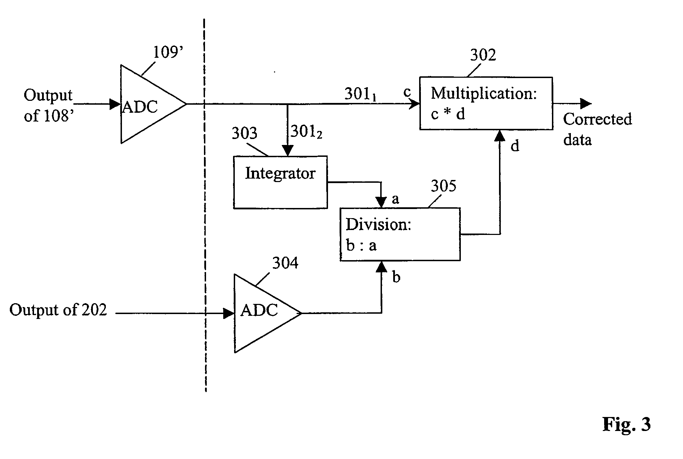

Fig. 3 shows a preferred embodiment for performing gain compensation of the first feedback branch as it is shown in figure 2. The RF downconverted signal of the first feedback branch is input to the analog-to-digital (ADC) conversion unit 109'. The digital output of this unit is then split into two different paths: On the first path 301₁ the output of the ADC unit 109' is input to the multiplicator 302, on the second path 301₂ the output of the ADC unit 109' is input to the integrator 303. The output of the power measurement unit 202 (of figure 2) is input to the analog-to-digital (ADC) converter 304, which can be a slow ADC.
The output of the integrator 303 serves as the dividend input to the division unit 305, while the output of the ADC unit 304 serves as divisor input to the division unit 305. The output of the division unit 305 is then multiplied with the analog-to-digital converted data on path 301₁ in the multiplication unit 302. The output of the multiplication unit 302 finally yields a correction factor for gain compensation of the first feedback branch. Such a preferred embodiment for gain compensation can be implemented with rather low effort and provides an efficient solution for gain compensation of the first feedback branch. It should be noted that the components shown in figure 3 may be implemented in one or more different devices, the broken line indicating the outline of the digital adaptation unit 103' as described with respect to figure 2 merely indicating one option.

## Claims

1. A method for improving the output signal accuracy of a transmitter with a forward branch for converting an input signal into a signal for transmission, the forward branch comprising an adaptation unit (103) for applying a predistortion to the input signal and a power amplifier (106), and with a first feedback branch (110), the first feedback branch (110) generating a feedback signal from the signal for transmission, said feedback signal being fed back to the adaptation unit (103), wherein, in said first feedback branch (110), the frequency of said signal for transmission is down-converted and wherein the down-converted signal is analogue-to-digital converted, and wherein the predistortion applied to the input signal is determined according to the feedback signal,
the method comprising the steps of:
- measuring the output power of said signal for transmission in a second feedback branch (201)
- converting analogue output power measurements of the second feedback branch to digital values,
- processing said analog-to-digital converted signal values of said first feedback branch by an integrating method,
- comparing the processed analogue-to-digital converted signal values of the first feedback branch with the digital values of the measurement,
- deriving a correction factor from said comparison, and
- multiplying said analogue-to-digital converted values of the first feedback branch with said correction factor for adjusting the predistortion according to said measurement of the output power.

2. The method according to claim 1, wherein the adjusting according to said measurement is performed on the feedback signal.

3. The method according to claim 1 or 2, wherein said measurement of the output power is performed by an integrating method.

4. The method according to any preceding claim, wherein the same time constant is used for integrating the output power measurement of the second feedback branch and for integrating said analog-to-digital-converted signal values of the first feedback branch.

5. A computer program product comprising program code portions for performing the steps of any of claims 1 to 4 when the computer program product is run on a computing device.

6. The computer program product of claim 5, stored on a computer readable recording medium.

7. A transmitter with a forward branch for converting an input signal into a signal for transmission, the forward branch comprising an adaptation unit (103) for applying a predistortion to the input signal and a power amplifier (106), and with a first feedback branch (110), the first feedback branch (110) being adapted to generate a feedback signal from the signal for transmission by down-converting the frequency of said signal for transmission and converting the down-converted signal analogue-to-digital and being connected to the adaptation unit (103), wherein the adaptation unit (103) is adapted to determine said predistortion according to the feedback signal, wherein
- the transmitter comprises a second feedback (201) branch with a measurement unit (202) for the output power of said signal for transmission, said second feedback branch (201) being connected to the adaptation unit (103), and wherein the transmitter comprises
- means for converting analogue output power measurements of the second feedback branch to digital values,
- means for processing said analog-to-digital converted signal values of said first feedback branch by an integrating method,
- means for comparing the processed analogue-to-digital converted signal values of the first feedback branch with the digital values of the measurement,
- means for deriving a correction factor from said comparison, and
- means for multiplying said analogue-to-digital converted values of the first feedback branch with said correction factor
for adjusting the predistortion according to said measurement of the output power.

8. The transmitter according to claim 7, wherein said first feedback branch comprises a frequency converter (108) and an analog-to-digital converter (109).

9. The transmitter according to claim 7 or 8, wherein said measurement unit (202) is an integrating measurement unit.

10. The transmitter according to any of the claims 7 to 9, wherein said adaptation unit (103) is adapted to adjust the predistortion according to said measurement.

11. The transmitter according to any of the claims 7 to 10, wherein said adaptation unit (103) is a predistortion unit.

## Patentansprüche

1. Verfahren zum Verbessern der Ausgangssignalgenauigkeit eines Senders mit einem Vorwärtszweig zum Umsetzen eines Eingangssignals in ein Signal zur Übertragung, wobei der Vorwärtszweig eine Anpassungseinheit (103) zum Anwenden einer Vorverzerrung auf das Eingangssignal und einen Leistungsverstärker (106) umfasst, und mit einem ersten Rückkopplungszweig (110), wobei der erste Rückkopplungszweig (110) aus dem Signal zur Übertragung ein Rückkopplungssignal erzeugt, wobei das Rückkopplungssignal wieder der Anpassungseinheit (103) zugeführt wird, wobei die Frequenz des Signals zur Übertragung im ersten Rückkopplungszweig (110) abwärts gemischt wird und wobei das abwärts gemischte Signal analog/digital-umgesetzt wird und wobei die auf das Eingangssignal angewendete Vorverzerrung gemäß dem Rückkopplungssignal bestimmt wird,
wobei das Verfahren die folgenden Schritte umfasst:
- Messen der Ausgangsleistung des Signals zur Übertragung in einem zweiten Rückkopplungszweig (201),
- Umsetzen von analogen Ausgangsleistungsmesswerten des zweiten Rückkopplungszweigs in digitale Werte,
- Verarbeiten der analog/digital-umgesetzten Signalwerte des ersten Rückkopplungszweigs mit einem Integrierverfahren,
- Vergleichen der verarbeiteten analog/digital-umgesetzten Signalwerte des ersten Rückkopplungszweigs mit den digitalen Werten der Messung,
- Ableiten eines Korrekturfaktors aus dem Vergleich und
- Multiplizieren der analog/digital-umgesetzten Werte des ersten Rückkopplungszweigs mit dem Korrekturfaktor zum Anpassen der Vorverzerrung gemäß der Messung der Ausgangsleistung.

2. Verfahren nach Anspruch 1, wobei das Anpassen gemäß der Messung an dem Rückkopplungssignal durchgeführt wird.

3. Verfahren nach Anspruch 1 oder 2, wobei die Messung der Ausgangsleistung mit einem Integrierverfahren durchgeführt wird.

4. Verfahren nach einem der vorhergehenden Ansprüche, wobei dieselbe Zeitkonstante für das Integrieren der Ausgangsleitungsmessung des zweiten Rückkopplungszweigs und für das Integrieren der analog/digital-umgesetzten Signalwerte des ersten Rückkopplungszweigs verwendet wird.

5. Computerprogrammprodukt, umfassend Programmcodeteile zum Durchführen der Schritte nach einem der Ansprüche 1 bis 4, wenn das Computerprogrammprodukt auf einer Rechenvorrichtung ausgeführt wird.

6. Computerprogrammprodukt nach Anspruch 5, das auf einem maschinenlesbaren Aufzeichnungsmedium gespeichert ist.

7. Sender mit einem Vorwärtszweig zum Umsetzen eines Eingangssignals in ein Signal zur Übertragung, wobei der Vorwärtszweig eine Anpassungseinheit (103) zum Anwenden einer Vorverzerrung auf das Eingangssignal und einen Leistungsverstärker (106) umfasst, und mit einem ersten Rückkopplungszweig (110), wobei der erste Rückkopplungszweig (110) aus dem Signal zur Übertragung ein Rückkopplungssignal erzeugt, indem er die Frequenz des Signals zur Übertragung abwärts mischt und das abwärts gemischte Signal analog/digital-umsetzt, und mit der Anpassungseinheit (103) verbunden ist, wobei die Anpassungseinheit (103) dazu adaptiert ist, die Vorverzerrung gemäß dem Rückkopplungssignal zu bestimmen, wobei
- der Sender einen zweiten Rückkopplungszweig (201) mit einer Messeinheit (202) für die Ausgangsleistung des Signals zur Übertragung umfasst, wobei der zweite Rückkopplungszweig (201) mit der Anpassungseinheit (103) verbunden ist und wobei der Sender Folgendes umfasst:
- Mittel zum Umsetzen von analogen Ausgangsleistungsmesswerten des zweiten Rückkopplungszweigs in digitale Werte,
- Mittel zum Verarbeiten der analog/digital-umgesetzten Signalwerte des ersten Rückkopplungszweigs mit einem Integrierverfahren,
- Mittel zum Vergleichen der verarbeiteten analog/digital-umgesetzten Signalwerte des ersten Rückkopplungszweigs mit den digitalen Werten der Messung,
- Mittel zum Ableiten eines Korrekturfaktors aus dem Vergleich und
- Mittel zum Multiplizieren der analog/digital-umgesetzten Werte des ersten Rückkopplungszweigs mit dem Korrekturfaktor zum Anpassen der Vorverzerrung gemäß der Messung der Ausgangsleistung.

8. Sender nach Anspruch 7, wobei der erste Rückkopplungszweig einen Frequenzumsetzer (108) und einen Analog/Digital-Umsetzer (109) umfasst.

9. Sender nach Anspruch 7 oder 8, wobei die Messeinheit (202) eine integrierende Messeinheit ist.

10. Sender nach einem der Ansprüche 7 bis 9, wobei die Anpassungseinheit (103) dazu adaptiert ist, die Vorverzerrung gemäß der Messung anzupassen.

11. Sender nach einem der Ansprüche 7 bis 10, wobei die Anpassungseinheit (103) eine Vorverzerrungseinheit ist.

## Revendications

1. Procédé pour améliorer la précision du signal de sortie d'un émetteur comportant une branche de sortie pour convertir un signal d'entrée en un signal à transmettre, la branche de sortie comprenant une unité d'adaptation (103) pour appliquer une prédistorsion au signal d'entrée et un amplificateur de puissance (106) et comportant une première branche de rétroaction (110), la première branche de rétroaction (110) générant un signal de rétroaction à partir du signal à transmettre, ledit signal de rétroaction étant réinjecté dans l'unité d'adaptation (103), moyennant quoi, dans ladite première branche de rétroaction (110), la fréquence dudit signal à transmettre est convertie à la fréquence inférieure et moyennant quoi le signal à fréquence convertie à la baisse est converti de l'analogique au numérique et moyennant quoi la prédistorsion appliquée au signal d'entrée est déterminée en fonction du signal de rétroaction,
le procédé comprenant les étapes consistant à :
- mesurer la puissance de sortie dudit signal à transmettre dans une seconde branche de rétroaction (201)
- convertir les mesures de puissance de sortie analogique de la seconde branche de rétroaction en valeurs numériques,
- traiter lesdites valeurs de signal converties de l'analogique au numérique de ladite première branche de rétroaction par un procédé intégrateur,
- comparer les valeurs de signal converties de l'analogique au numérique traitées de la première branche de rétroaction avec les valeurs numériques de la mesure,
- déduire un facteur de correction de ladite comparaison, et
- multiplier lesdites valeurs converties de l'analogique au numérique de la première branche de rétroaction avec ledit facteur de correction afin de régler la prédistorsion en fonction de ladite mesure de la puissance de sortie.

2. Procédé selon la revendication 1, dans lequel le réglage en fonction de ladite mesure est effectué sur le signal de rétroaction.

3. Procédé selon la revendication 1 ou 2, dans lequel ladite mesure de la puissance de sortie est effectuée par un procédé intégrateur.

4. Procédé selon l'une quelconque des revendications précédentes, dans lequel la même constante de temps est utilisée pour intégrer la mesure de puissance de sortie de la seconde branche de rétroaction et pour intégrer lesdites valeurs de signal converties de l'analogique au numérique de la première branche de rétroaction.

5. Produit de programme informatique comprenant des portions de code de programme pour effectuer les étapes de l'une quelconque des revendications 1 à 4 lorsque le produit de programme informatique est exécuté sur un dispositif informatique.

6. Produit de programme informatique de la revendication 5, mémorisé sur un support d'enregistrement pouvant être lu par un ordinateur.

7. Emetteur comportant une branche de sortie pour convertir un signal d'entrée en un signal à transmettre, la branche de sortie comprenant une unité d'adaptation (103) pour appliquer une prédistorsion au signal d'entrée et un amplificateur de puissance (106), et comportant une première branche de rétroaction (110), la première branche de rétroaction (110) étant adaptée afin de générer un signal de rétroaction à partir du signal à transmettre en convertissant à la fréquence inférieure la fréquence dudit signal à transmettre et en convertissant le signal à fréquence convertie à la baisse de l'analogique au numérique et étant connecté à l'unité d'adaptation (103), moyennant quoi l'unité d'adaptation (103) est adaptée afin de déterminer ladite prédistorsion en fonction du signal de rétroaction, moyennant quoi
- l'émetteur comprend une seconde branche de rétroaction (201) comportant une unité de mesure (202) de la puissance de sortie dudit signal à transmettre, ladite seconde branche de rétroaction (201) étant connectée à l'unité d'adaptation (103) et moyennant quoi l'émetteur comprend .
- un moyen pour convertir les mesures de puissance de sortie analogique de la seconde branche de rétroaction en valeurs numériques,
- un moyen pour traiter lesdites valeurs de signal converties de l'analogique au numérique de ladite première branche de rétroaction par un procédé intégrateur
- un moyen pour comparer les valeurs de signal converties de l'analogique au numérique traitées de la première branche de rétroaction avec les valeurs numériques de la mesure,
- un moyen pour déduire un facteur de correction de ladite comparaison, et
- un moyen pour multiplier lesdites valeurs converties de l'analogique au numérique de la première branche de rétroaction avec ledit facteur de correction afin de régler la prédistorsion en fonction de ladite mesure de la puissance de sortie.

8. Emetteur selon la revendication 7, dans lequel ladite première branche de rétroaction comprend un convertisseur de fréquence (108) et un convertisseur analogique à numérique (109).

9. Emetteur selon la revendication 7 ou 8, dans lequel ladite unité de mesure (202) est une unité de mesure intégrante.

10. Emetteur selon l'une des revendications 7 à 9, dans lequel ladite unité d'adaptation (103) est adaptée afin de régler la prédistorsion en fonction de ladite mesure.

11. Emetteur selon l'une des revendications 7 à 10, dans lequel ladite unité d'adaptation (103) est une unité de prédistorsion.
